Europäisches Patentamt

European Patent Office

Office européen des brevets

(11) Publication number: **0 349 696**
**A1**

## (12) EUROPEAN PATENT APPLICATION

(21) Application number: 88401787.2

(22) Date of filing: 08.07.88

(51) Int. Cl.4: **H01L 21/90 , H01L 21/60**

The title of the invention has been amended (Guidelines for Examination in the EPO, A-III, 7.3).

(43) Date of publication of application:
**10.01.90 Bulletin 90/02**

(84) Designated Contracting States:
**FR**

(71) Applicant: **L'AIR LIQUIDE, SOCIETE ANONYME POUR L'ETUDE ET L'EXPLOITATION DES PROCEDES GEORGES CLAUDE**
**75, Quai d'Orsay**
**F-75321 Paris Cédex 07(FR)**

(72) Inventor: **Hirase, Ikuo**
**L'AIR LIQUIDE LABORATORIES K.K. 5-9-9 Tokodai**
**Toyosato-amchi Tsucuba-gun 300-26(JP)**

(74) Representative: Vesin, Jacques et al
**L'AIR LIQUIDE, SOCIETE ANONYME POUR L'ETUDE ET L'EXPLOITATION DES PROCEDES GEORGES CLAUDE 75, quai d'Orsay**
**F-75321 Paris Cédex 07(FR)**

(54) **Method of depositing metal on an aluminium substrate.**

(57) A method of depositing a metal on an aluminum substrate includes the steps of performing a surface treatment of an aluminum substrate (2), and depositing a metal (5) on the surface of the aluminum substrate subjected to the surface treatment. In the surface treatment of the aluminum substrate (2), the aluminum substrate (2) is treated by a gas containing at least one member selected from the group consisting of $NCl_3$, $HCl$, and $Cl_2$ at a temperature of 50 to 600 °C. A natural oxide (4) on the aluminum substrate surface (2) is substantially completely removed by the surface treatment.

F I G. 3

## METHOD OF DEPOSITING METAL ON ALUMINUM

The present invention relates to a method of depositing a metal on aluminum and, more particularly, to a surface treatment performed on an aluminum surface when a metal is deposited on the aluminum surface.

In the manufacture of semiconductor devices, a metal deposition process, especially a selective deposition process is a very important technique for forming electrodes, contacts, interconnections, and the like. As such a selective deposition process, selective deposition of a metal such as tungsten performed by low pressure chemical vapor deposition (to be referred to as LPCVD hereinafter) is recently receiving a great deal of attention.

Selective deposition of tungsten on an aluminum surface by LPCVD is normally performed as follows. That is, an Si wafer having on its surface an aluminum layer covered with a patterned film such as an $SiO_2$ film is placed in a CVD chamber, and a gas mixture of $WF_6$ gas and $H_2$ gas is supplied into the chamber. Then, W is selectively deposited on the surface of the aluminum layer not covered with the patterned film by reduction of $WF_6$.

Selective deposition of W performed by LPCVD described above has a serious problem, i.e., a problem of presence of a natural oxide on the aluminum layer surface to be deposited. Since the natural oxide is present, the surface of the deposited W film is not smooth, and the film thickness becomes nonuniform. The reason for this is as follows.

It is assumed that a W film having a self limiting thickness is formed in an initial stage of the deposition process. However, the thickness of the thin W film is largely affected by a natural oxide present on the aluminum layer surface. That is, because of the presence of this natural oxide, a W film having an uneven surface, i.e., having a nonuniform thickness is formed.

When such a metal film with an uneven surface and a nonuniform thickness is used to form electrodes, contacts, interconnections, and the like, those having good characteristics cannot be obtained. In addition, when another interconnection layer is formed on the metal film, disconnections may occur. Furthermore, the natural oxide film present on the aluminum layer surface increases a contact resistance.

In order to remove the undesired natural oxide film on the aluminum layer surface, wet etching is performed using chloride solution or the like. However, wet etching is time-consuming and troublesome because washing and drying steps must be performed after an etching step. In addition, even after removal of a natural oxide film by wet etching, another natural oxide film is formed immediately upon exposure to air.

It is, therefore, an object of the present invention to provide a method of removing a natural oxide on an aluminum surface and depositing a metal having a low contact resistance with aluminum, a smooth surface, and a uniform film thickness.

According to the present invention, there is provided a method of depositing a metal on an aluminum substrate, comprising the steps of: performing a surface treatment of an aluminum substrate; and depositing a metal on the surface of the aluminum substrate subjected to the surface treatment, wherein in the surface treatment of the aluminum substrate, the aluminum substrate is treated by a gas containing at least one member selected from the group consisting of $NCl_3$, $HCl$ and $Cl_2$ at a temperature of 50 to 600 °C.

A gas used in the treatment may contain an inert gas such as helium or argon as a carrier gas.

Examples of the metal to be deposited on the aluminum substrate are molybdenum, tungsten, molybdenum silicide, tungsten silicide, aluminum, titanium, titanium nitride, titanium tungsten, copper, and polycrystalline silicon.

Examples of the method of depositing the metal are vapor evaporation, chemical vapor deposition (CVD), plasma CVD, ion plating, and sputtering.

Deposition of the metal on the aluminum substrate can be selectively performed using a patterned film or performed on the entire surface not using the patterned film.

In the present invention, the temperature of the surface treatment is 50 to 600 °C, and preferably, 200 to 350 °C. If the temperature is less than 50 °C, a time required for the treatment becomes too long. If the temperature exceeds 600 °C, other semiconductor elements formed on the wafer are adversely affected.

In the present invention, although the surface treatment time depends on the type of a gas and a temperature condition, it is preferably 10 seconds to 10 minutes.

In the present invention, the pressure of an atmosphere in the surface treatment is preferably $10^{-3}$ to 100 Torr.

According to the method of the present invention, the surface of an aluminum substrate is treated by a predetermined gas prior to deposition of a metal. Therefore, a natural oxide on the aluminum substrate surface can be completely removed at a comparatively low temperature in a short period of time. As a result, by subsequently depositing a metal, a metal film having a low contact resistance with aluminum, a smooth surface, and a uniform thickness can be formed.

The present invention can be understood more clearly by the following detailed description taken in conjunction with the accompanying drawings, in which:

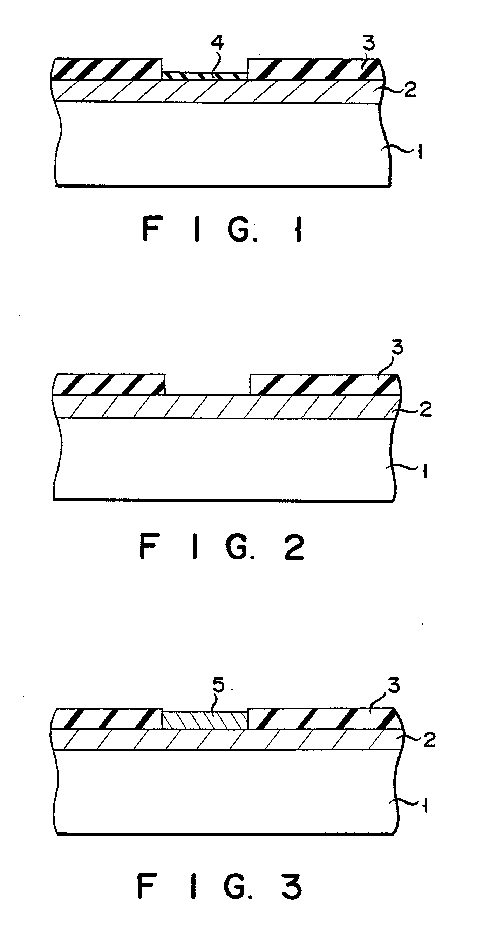

Figs. 1 to 3 are sectional views showing steps of depositing a metal on an aluminum substrate according to a method of the present invention.

In the method of the present invention, when an aluminum substrate is subjected to a surface treatment using a predetermined gas at a predetermined temperature, a natural oxide film on the surface of the aluminum substrate is completely removed. Therefore, when a gas mixture of $WF_6$ gas and $H_2$ gas is subsequently supplied, a W film having a smooth surface and a uniform thickness is formed.

Example

Using a single wafer cold wall LPCVD reactor, tungsten was deposited on the surface of aluminum layer 2 covered with patterned film 3 consisting of an $SiO_2$ film as shown in Fig. 1 and formed on the surface of silicon wafer 1. Note that natural oxide 4 is present on the surface of layer 2.

First, wafer 1 (diameter: 4 inch) shown in Fig. 1 was placed on a hot plate disposed in a reaction chamber, and the interior of the reaction chamber was evacuated by a turbo molecular pump to obtain a pressure of $10^{-7}$ Torr. Note that a vacuum system in this apparatus comprises a rotary pump and a mechanical booster pump and can change the pressure in the reaction chamber within the range of $10^{-3}$ to 100 Torr. The pressure in the reaction chamber can be monitored by a capacitor manometer. The hot plate disposed at a central portion of the reaction chamber has a halogen lamp heater and therefore can rapidly and uniformly stabilize a temperature distribution on the wafer surface. The temperature of the wafer can be measured and controlled by an IR thermometer.

Then, $NCl_3$ gas was supplied into the reaction chamber at a flow rate of 20 SCCM (standard cubic centimeter per minute) to treat the aluminum layer surface. Treatment conditions were such that the pressure in the reaction chamber was 0.5 Torr, the treatment temperature was 300°C, and the treatment time was 30 seconds. By this treatment, natural oxide 4 on the surface of layer 2 was completely removed as shown in Fig. 2.

After the surface treatment, a gas mixture of $WF_6$ gas and $H_2$ gas ($WF_6$: 10 SCCM, $H_2$: 200 SCCM) was subsequently supplied to form W film 5 having a thickness of 6000 Å on the surface of layer 2 as shown in Fig. 3. Deposition conditions were such that the pressure in the reaction chamber was 0.5 Torr and the temperature therein was 500°C.

The surface of film 5 had no unevenness and was very smooth. When a state of an interface between layer 2 and film 5 was measured by an SEM, almost no natural oxide was present, and the thickness of film 5 was very uniform.

Claims

1. A method of depositing a metal on an aluminum substrate (2), comprising the steps of:
performing a surface treatment of an aluminum substrate (2); and
depositing a metal (5) on the surface of said aluminum substrate (2) subjected to the surface treatment,
characterized in that in the surface treatment of said aluminum substrate (2), said aluminum substrate (2) is treated by a gas containing at least one member selected from the group consisting of $NCl_3$, $HCl$ and $Cl_2$ at a temperature of 50 to 600°C.

2. A method according to claim 1, characterized in that the metal (5) to be deposited on said aluminum substrate (2) is selected from the group consisting of molybdenum, tungsten, molybdenum silicide, tungsten silicide, aluminum, titanium, titanium nitride, titanium tungsten, copper, and polycrystalline silicon.

3. A method according to claim 1, characterized in that the step of depositing the metal (5) is selected from the group consisting of vapor evaporation, chemical vapor deposition, ion plating, and sputtering.

4. A method according to claim 1, characterized in that deposition of the metal (5) is selectively performed on said aluminum substrate (2) having a patterned film thereon (3).

5. A method according to claim 1, characterized in that deposition of the metal (5) is performed on the entire surface of said substrate (2).

6. A method according to claim 1, characterized in that a temperature of the surface treatment is 200 to 350°C.

7. A method according to claim 1, characterized in that a time of the surface treatment is 10 seconds to 10 minutes.

8. A method according to claim 1, characterized in that a pressure of an atmosphere of the surface treatment is $10^{-3}$ to 100 Torr.

F I G. 1

F I G. 2

F I G. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| X | DE-A-1 900 119 (SIEMENS) * Claims 1-3,10,11 * & US-A-3 619 288 | 1 | H 01 L 21/90 H 01 L 21/60 |
| A | | 2-5 | |
| A | US-A-4 393 096 (GAJDA) * Claim 1 * | 1-3,5 | |
| X | SOLID STATE TECHNOLOGY, vol. 28, no. 12, December 1985, pages 51-59, Washington, New York, US; E.K. BROADBENT et al.: "Selective tungsten processing by low pressure CVD" * Page 55, line 27 - page 56, column 2, line 3; page 53, column 1, lines 46-56 * | 1 | |
| A | Idem | 2-4 | |
| A | US-A-4 605 479 (FAITH) * Claim 1; column 2, lines 9-17 * | 1-3,5 | |

TECHNICAL FIELDS SEARCHED (Int. Cl.4)

H 01 L
C 23 C

The present search report has been drawn up for all claims

| Place of search | Date of completion of the search | Examiner |
|---|---|---|
| THE HAGUE | 09-12-1988 | PHEASANT N.J. |